# EUROPEAN PATENT SPECIFICATION

(11) **EP 4 301 095 B1**
(45) Date of publication and mention of the grant of the patent: **17.07.2024**
(21) Application number: 22181146.6
(22) Date of filing: 27.06.2022
(51) Int. Cl.: H05B 45/54

(54) **LED MODULE WITH SURGE CURRENT PROTECTION**
LED-MODUL MIT STOSSSTROMSCHUTZ
MODULE À DEL AVEC PROTECTION CONTRE LE COURANT DE SURTENSION

(43) Date of publication of application: 03.01.2024
(73) Proprietor: Tridonic GmbH & Co. KG, 6851 Dornbirn (AT)
(72) Inventor: Mozsáry, András, 6850 Dornbirn (AT)
(74) Representative: Rupp, Christian

(56) References cited:
- WO-A1-2015/124520
- US-A1- 2010 270 935
- US-B2- 9 516 720

## Description

### TECHNICAL FIELD OF THE INVENTION

The invention relates to a LED module. In particular, the invention relates LED modules with surge current protection, as well as to a system comprising such LED module and a driver electrically supplying said LED module.

### BACKGROUND OF THE INVENTION

The 230 V AC electrical power grid can suffer from different disturbances, such as the surge disturbance, which can be harmful for lighting applications. Two different types of this disturbance are known: the so-called differential mode surge and the so-called common mode surge. The differential mode surge (between L and N conductors) is related to the LED driver protection circuitry, while the common mode surge (from L+N towards PE, earth, conductor) is able to bypass the LED driver, even SELV LED driver, because of the presence of primary/secondary capacitors inside the LED driver. Primary/secondary capacitors are used for EMC (electromagnetic compatibility) requirements posed on LED drivers.

Common mode surge can damage the LED components by reverse bias overvoltage junction breakdown. Preventive measures should be taken in order to avoid these damages.

The PE conductor is very close to the LED in case of aluminum-core PCB assembly and/or heatsink. For example, WO2015124520A1, in Figure 3, illustrates the discharge path activated in the event of a common mode surge. Moreover, WO2015124520A1, in front page, shows an implementation of ceramic capacitors to bypass LED components.

However, ceramic capacitors are expensive in the manufacturing. Moreover, luminaires containing aluminum-core PCB and/or heatsink may be very sensitive to common mode surge disturbance.

Thus, it is an objective to provide an improved LED module which avoids the above mentioned disadvantages.

### SUMMARY OF THE INVENTION

The object of the present invention is achieved by the solution provided in the enclosed independent claims. Advantageous implementations of the present invention are further defined in the dependent claims.

According to a first aspect of the invention, a LED module is provided.

The LED module comprises at least two LEDs connected in series and arranged on a printed circuit board, PCB, the printed circuit board comprising two terminals for electrically supplying the LEDs off a driver. Moreover, it comprises a surge current protection structure comprising: a first metal surface arranged on the PCB and connected to an anode potential of the series connection of LEDs; and a second metal surface arranged on the PCB and connected to a cathode potential of the series connection of LEDs. The first and second metal surfaces are furthermore respectively connected in a heat-conducting manner with each of the LEDs of a first group of LEDs at the anode potential side of the series connection of LEDs and with each of the LEDs of a second group of LEDs at the cathode potential side of the series connection of LEDs.

This provides the advantage that the incident surge impulse is discharge in a controlled manner.

In a preferred embodiment, each of the first metal surface and second metal surface has the same surface within a margin of 10%, preferably 5%.

In a preferred embodiment, the surface of the first or second metal surface is at least a footprint surface of the LED, preferably at least 200%, more preferred 300% thereof.

In a preferred embodiment, the first metal surface and second metal surface comprise copper.

In a preferred embodiment, the LED module further comprises a backside of the PCB board designed as a common capacitor electrode for the first and second metal surfaces.

In a preferred embodiment, the backside of the PCB comprises a heat sink.

In a preferred embodiment, the LED module comprises an even number of LEDs and wherein the surface of the first metal surface and the surface of the second metal surface are essentially the same.

In a preferred embodiment, the LED module comprises an uneven number of LEDs. The surface area of the second metal surface also in this case may be made equal to the surface area of the first metal surface by adjusting corresponding copper areas in size.

According to a second aspect, the invention relates to a system comprising a driver and an LED module according to the first aspect and any one of the preferred embodiments thereof.

### BRIEF DESCRIPTION OF THE DRAWINGS

The invention will be explained in the followings together with the figures.
- Fig. 1: shows an embodiment of a system comprising a driver and a LED module; and
- Fig. 2: shows an embodiment of a system comprising a driver and a LED module.

### DETAILED DESCRIPTION OF THE PREFERRED EMBODIMENTS

Aspects of the present invention are described herein in the context of a system comprising a LED driver and LED module.

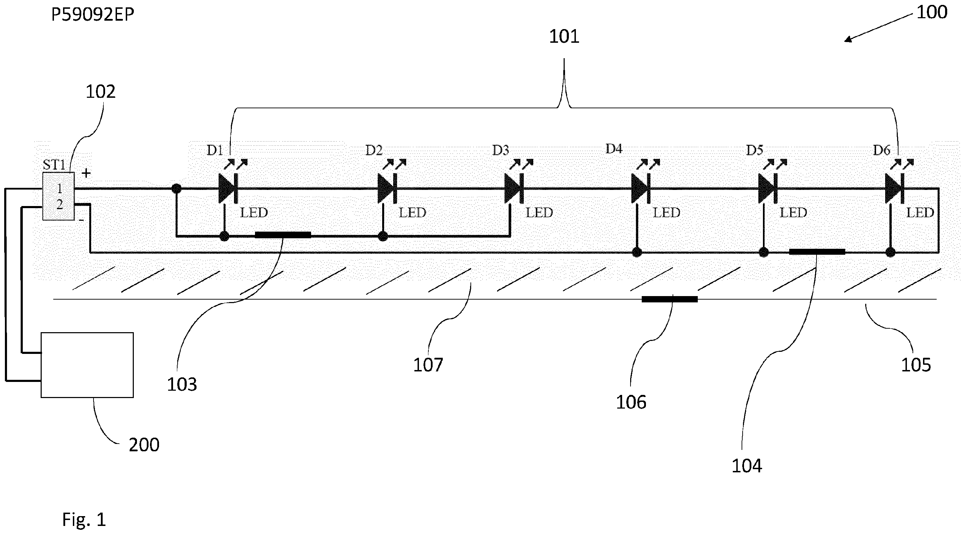

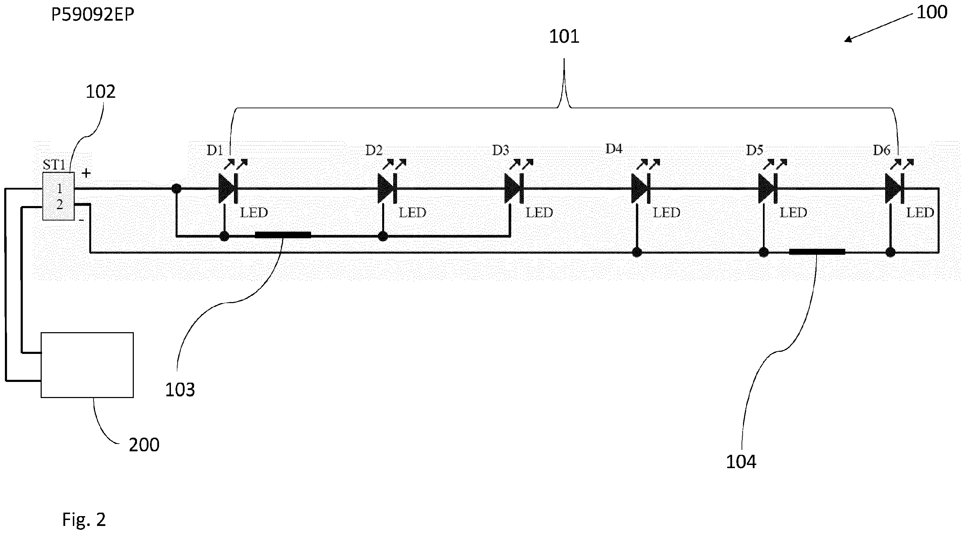

Fig. 1 and Fig. 2 show a system 100 comprising a driver 200 and a LED module 101 according to an embodiment, wherein Fig. 1 is a side view and Fig.2 is a top view of the system 100.

The LED module 101 comprises at least two LEDs D1, D2, D3, D4, D5, D6 connected in series and arranged on a printed circuit board, PCB. The printed circuit board comprises two terminals 1, 2 of a connector 102 for electrically supplying the LEDs D1, D2, D3, D4, D5, D6 off a driver 200. The LED module 101 is connected to the driver 200 via the connector 102. Moreover, the LED module 101 comprises a surge current protection structure comprising: a first metal surface 103 arranged on the PCB and connected to an anode potential of the series connection of LEDs D1, D2, D3 and a second metal surface 104 arranged on the PCB and connected to a cathode potential of the series connection of LEDs D4, D5, D6. The first and second metal surfaces 103, 104 are furthermore respectively connected in a heat-conducting manner with each of the LEDs D1, D2, D3 of a first group of LEDs D1, D2, D3 at the anode potential side of the series connection of LEDs and with each of the LEDs D4, D5, D6 of a second group of LEDs D4, D5, D6 at the cathode potential side of the series connection of LEDs.

In such a LED module 101, LEDs may be used each having three connectors, one for the anode, one for the cathode and a third one which is intended to remove heat from the LED module 101.

The first metal surface 103 or copper pad on the circuit board to which this third connector is connected is relatively large compared to the surface of the connections for electrically supplying the LEDs in order to ensure that a sufficient amount of heat is removed from the LED module 101. According to the invention, these areas with copper and connected to the LEDs can advantageously be used and designed, as to their electrical potential, in order to establish capacitances, which are able to cover the surge bursts instead of dedicated capacitors.

The backside 105 of the circuit board, (eventually equipped with heat sink) is the entry point of the surge pulse. The surge pulse can be transmitted to the front side copper areas of the circuit board through capacitive coupling. The backside 105 of the circuit board is acting as a common electrode for all capacitances.

The copper areas (or first metal surface 103 and second metal surface 104) establishing the two electrodes of the capacitances may have similar sizes so that an equal distribution for the plus connected copper areas and the minus connected copper areas can be achieved. Thus, the layout should be adapted in order to ensure that each the two groups of copper areas may provide 50% of the entire area. In case that through holes or the like are present on the LED module 101, the size is set accordingly. The distribution of the copper areas may be equal in case that there is an even number of LEDs. However, even an uneven number of LEDs can be present in case that the corresponding copper areas are adjusted in size.

The 50% areas are connected to the LED plus terminal of the connector 102 on the one side and to the LED minus terminal of the connector 102 on the other side so that a capacitance is formed by the two groups. The resulting capacitance is a magnitude smaller than the magnitude of the capacitors used in the prior art.

The present invention has the advantage that a synergistic effect is achieved, which avoids additional components and thereby reduces the costs for the entire LED module 101 without losing any performance.

### List of reference signs

- 1: terminal
- 2: terminal
- 100: system
- 101: LED module
- 102: connector
- 103: first metal surface
- 104: second metal surface
- 105: backside of PCB
- 106: common electrode
- 107: isolating layer
- 200: driver
- D1,...,D6: LED

## Claims

1. A LED module (101) comprising,
- at least two LEDs (D1, D2, D3, D4, D5, D6) connected in series and arranged on a printed circuit board, PCB, the printed circuit board comprising two terminals (1, 2) for electrically supplying the LEDs (D1, D2, D3, D4, D5, D6) off a driver (102);
- a surge current protection structure comprising:
- a first metal surface (103) arranged on the PCB and connected to an anode potential of the series connection of LEDs (D1, D2); and
- a second metal surface (104) arranged on the PCB and connected to a cathode potential of the series connection of LEDs (D1, D2, D3, D4, D5, D6),
the first and second metal surfaces (103, 104) being furthermore respectively connected in a heat-conducting manner with each of the LEDs;
**characterised in that**
said connection of the first and second metal surfaces (103, 104) in a heat-conducting manner with the LEDs (D1, D2, D3, D4, D5, D6) is respectively with each of the LEDs (D1, D2, D3) of a first group of LEDs (D1, D2, D3) at the anode potential side of the series connection of LEDs (D1, D2, D3, D4, D5, D6) and with each of the LEDs (D4, D5, D6) of a second group of LEDs (D4, D5, D6) at the cathode potential side of the series connection of LEDs (D1, D2, D3, D4, D5, D6).

2. The LED module (101) of claim 1, wherein each of the first metal surface (103) and second metal surface (104) has the same surface area within a margin of 10%, preferably 5%.

3. The LED module (101) of claim 1 or 2, wherein the surface of the first (103) or second metal surface (104) is at least a footprint surface of the LED, preferably at least 200%, more preferred 300% thereof.

4. The LED module (101) of any one of the preceding claims, wherein the first metal surface (103) and second metal surface (104) comprise copper.

5. The LED module (101) of any one of the preceding claims further comprising a backside (105) of the PCB board designed as a common capacitor electrode (106) for the first (103) and second metal surfaces (104).

6. The LED module (101) of claim 5, wherein the backside (106) of the PCB comprises a heat sink.

7. The LED module (101) of any one of the preceding claims, wherein the LED module (101) comprises an even number of LEDs (D1, D2, D3, D4, D5, D6) and wherein the surface area of the first metal surface (103) and the surface area of the second metal surface (104) are essentially equal.

8. The LED module (101) of any one of the preceding claims 1 to 6, wherein the LED module (101) comprises an uneven number of LEDs (D1, D2, D3, D4, D5, D6).

9. A system (100) comprising a driver (200) and an LED module (101) according to any one of the preceding claims, whereas the LED module (101) is connected to the driver via a connector (102) and the driver (200) is electrically supplying the LED module (101).

## Patentansprüche

1. LED-Modul (101), umfassend
- mindestens zwei in Reihe geschaltete und auf einer Leiterplatte, PCB, angeordnete LEDs (D1, D2, D3, D4, D5, D6), wobei die Leiterplatte zwei Anschlüsse (1, 2) zur elektrischen Versorgung der LEDs (D1, D2, D3, D4, D5, D6) von einem Treiber (102) umfasst;
- eine Stoßstromschutzstruktur, umfassend:
- eine erste Metalloberfläche (103), die auf der PCB angeordnet und mit einem Anodenpotenzial der Reihenschaltung der LEDs (D1, D2) verbunden ist; und
- eine zweite Metalloberfläche (104), die auf der PCB angeordnet und mit einem Kathodenpotenzial der Reihenschaltung der LEDs (D1, D2, D3, D4, D5, D6) verbunden ist,
wobei die erste und die zweite Metalloberfläche (103, 104) weiterhin jeweils mit jeder der LEDs wärmeleitend verbunden sind;
**dadurch gekennzeichnet, dass** die wärmeleitende Verbindung der ersten und der zweiten Metalloberfläche (103, 104) mit den LEDs (D1, D2, D3, D4, D5, D6) jeweils mit jeder der LEDs (D1, D2, D3) einer ersten Gruppe der LEDs (D1, D2, D3) auf der Anodenpotenzialseite der Reihenschaltung der LEDs (D1, D2, D3, D4, D5, D6) und mit jeder der LEDs (D4, D5, D6) einer zweiten Gruppe der LEDs (D4, D5, D6) auf der Kathodenpotenzialseite der Reihenschaltung der LEDs (D1, D2, D3, D4, D5, D6) erfolgt.

2. LED-Modul (101) nach Anspruch 1, wobei jede der ersten Metalloberfläche (103) und der zweiten Metalloberfläche (104) jeweils innerhalb einer Toleranz von 10 %, vorzugsweise 5 %, den gleichen Oberflächenbereich aufweist.

3. LED-Modul (101) nach Anspruch 1 oder 2, wobei die Oberfläche der ersten (103) oder der zweiten Metalloberfläche (104) mindestens eine Grundoberfläche der LED, vorzugsweise mindestens 200 %, bevorzugter 300 %, davon ist.

4. LED-Modul (101) nach einem der vorhergehenden Ansprüche, wobei die erste Metalloberfläche (103) und die zweite Metalloberfläche (104) Kupfer umfassen.

5. LED-Modul (101) nach einem der vorhergehenden Ansprüche, ferner umfassend eine Rückseite (105) der PCB-Platte, die als gemeinsame Kondensatorelektrode (106) für die erste (103) und die zweite Metalloberfläche (104) ausgebildet ist.

6. LED-Modul (101) nach Anspruch 5, wobei die Rückseite (106) der PCB einen Kühlkörper umfasst.

7. LED-Modul (101) nach einem der vorhergehenden Ansprüche, wobei das LED-Modul (101) eine gerade Anzahl von LEDs (D1, D2, D3, D4, D5, D6) umfasst und wobei der Oberflächenbereich der ersten Metalloberfläche (103) und der Oberflächenbereich der zweiten Metalloberfläche (104) im Wesentlichen gleich sind.

8. LED-Modul (101) nach einem der vorhergehenden Ansprüche 1 bis 6, wobei das LED-Modul (101) eine ungerade Anzahl der LEDs (D1, D2, D3, D4, D5, D6) umfasst.

9. System (100), umfassend einen Treiber (200) und ein LED-Modul (101) nach einem der vorhergehenden Ansprüche, wobei das LED-Modul (101) über einen Verbinder (102) mit dem Treiber verbunden ist und der Treiber (200) das LED-Modul (101) mit Strom versorgt.

## Revendications

1. Module de DEL (101), comprenant,
- au moins deux DEL (D1, D2, D3, D4, D5, D6) connectées en série et disposées sur une carte de circuit imprimé, PCB, la carte de circuit imprimé comprenant deux bornes (1, 2) pour alimenter électriquement les DEL (D1, D2, D3, D4, D5, D6) à partir d'un circuit d'attaque (102) ;
- une structure de protection contre le courant de surcharge comprenant :
- une première surface métallique (103) disposée sur la carte de circuit imprimé et connectée à un potentiel d'anode de la connexion en série des DEL (D1, D2) ; et
- une seconde surface métallique (104) disposée sur la carte de circuit imprimé et connectée à un potentiel de cathode de la connexion en série des DEL (D1, D2, D3, D4, D5, D6),
les première et seconde surfaces métalliques (103, 104) sont en outre reliées respectivement à chacune des DEL de manière à assurer la conduction de la chaleur ;
**caractérisé en ce que** ladite connexion des première et seconde surfaces métalliques (103, 104) par conduction de la chaleur avec les DEL (D1, D2, D3, D4, D5, D6) se trouve respectivement avec chacune des DEL (D1, D2, D3) d'un premier groupe de DEL (D1, D2, D3) du côté du potentiel de l'anode de la connexion en série des DEL (D1, D2, D3, D4, D5, D6) et avec chacune des DEL (D4, D5, D6) d'un second groupe de DEL (D4, D5, D6) du côté du potentiel de la cathode de la connexion en série des DEL (D1, D2, D3, D4, D5, D6).

2. Module de DEL (101) selon la revendication 1, dans lequel la première surface métallique (103) et la seconde surface métallique (104) ont la même surface avec une marge de 10 %, de préférence 5 %.

3. Module de DEL (101) selon la revendication 1 ou 2, dans lequel la surface de la première (103) ou de la seconde surface métallique (104) est au moins une surface d'empreinte de la DEL, de préférence au moins 200 %, plus préférentiellement 300 % de celle-ci.

4. Module de DEL (101) selon l'une quelconque des revendications précédentes, dans lequel la première surface métallique (103) et la seconde surface métallique (104) sont constituées de cuivre.

5. Module de DEL (101) selon l'une quelconque des revendications précédentes comprenant en outre une face arrière (105) de la carte PCB conçue comme une électrode de condensateur commune (106) pour la première (103) et la seconde surface métallique (104).

6. Module de DEL (101) selon la revendication 5, dans lequel la face arrière (106) de la carte de circuit imprimé comprend un dissipateur thermique.

7. Module de DEL (101) selon l'une quelconque des revendications précédentes, dans lequel le module de DEL (101) comprend un nombre pair de DEL (D1, D2, D3, D4, D5, D6) et dans lequel la surface de la première surface métallique (103) et la surface de la seconde surface métallique (104) sont essentiellement égales.

8. Module de DEL (101) selon l'une quelconque des revendications précédentes 1 à 6, dans lequel le module de DEL (101) comprend un nombre impair de DEL (D1, D2, D3, D4, D5, D6).

9. Système (100) comprenant un circuit d'attaque (200) et un module de DEL (101) selon l'une quelconque des revendications précédentes, le module de DEL (101) étant connecté au circuit d'attaque par le biais d'un connecteur (102) et le circuit d'attaque (200) alimentant électriquement le module de DEL (101).
